# EUROPÄISCHE PATENTANMELDUNG

(11) **EP 2 990 817 A1**
(43) Veröffentlichungstag der Anmeldung: **02.03.2016**
(21) Anmeldenummer: 14183051.3
(22) Anmeldetag: 01.09.2014
(51) Int. Cl.: G01R 31/28

(54) **Kompakte Prüfanordnung für Leiterplatten**

(71) Anmelder: Siemens Aktiengesellschaft, 80333 München (DE)
(72) Erfinder: Bündgens, Georg, 91074 Herzogenaurach (DE); Dittrich, Thomas, 91074 Herzogenaurach (DE); Hofmann, Lars, 90587 Obermichelbach (DE); Rebhan, Herbert, 96191 Viereth-Trunstadt (DE)

(57) **Zusammenfassung**

Eine Prüfanordnung für eine mit elektronischen Bauelementen (4) bestückte Leiterplatte (3) weist einen Grundkörper (1) auf, der seinerseits eine Aufnahme (2) für die Leiterplatte (3) aufweist. In der Aufnahme (2) ist eine Vielzahl von Kontakten (5) angeordnet, die bei in die Aufnahme (2) eingesetzter Leiterplatte (3) Kontaktstellen (6) der Leiterplatte (3) elektrisch kontaktieren. Die Kontakte (5) sind über ein Schaltnetzwerk (7) mit Signalgeneratoren (8) und Signalerfassungseinrichtungen (9) verbindbar. Eine programmgesteuerte Logikeinheit (10) ist mit dem Schaltnetzwerk (7), den Signalgeneratoren (8) und den Signalerfassungseinrichtungen (9) verbunden. Ein Programmspeicher (11), in dem ein Steuerprogramm (SP) für die Logikeinheit (10) hinterlegt ist, ist mit der Logikeinheit (10) datentechnisch verbunden. Entsprechend dem im Programmspeicher (11) hinterlegten Steuerprogramm (SP) steuert die Logikeinheit (10) das Schaltnetzwerk (7), die Signalgeneratoren (8) und die Signalerfassungseinrichtungen (9) dynamisch an, nimmt von den Signalerfassungseinrichtungen (9) Messresultate (M) entgegen, nimmt anhand der entgegengenommenen Messresultate (M) eine Gesamtbewertung (G) der Leiterplatte (3) vor und gibt zumindest die Gesamtbewertung (G) über eine Schnittstelle (12) aus. Das Schaltnetzwerk (7), die Signalgeneratoren (8), die Signalerfassungseinrichtungen (9), die Logikeinheit (10), der Programmspeicher (11) und die Schnittstelle (12) sind in einen innerhalb des Grundkörpers (1) angeordneten ASIC (13) der Prüfanordnung integriert.

## Beschreibung

Die vorliegende Erfindung geht aus von einer Prüfanordnung für eine mit elektronischen Bauelementen bestückte Leiterplatte,
- wobei die Prüfanordnung einen Grundkörper aufweist,
- wobei der Grundkörper eine Aufnahme für die Leiterplatte aufweist,
- wobei in der Aufnahme eine Vielzahl von Kontakten angeordnet ist, die bei in die Aufnahme eingesetzter Leiterplatte Kontaktstellen der Leiterplatte elektrisch kontaktieren,
- wobei die Kontakte über ein Schaltnetzwerk mit einer Anzahl von Signalgeneratoren und einer Anzahl von Signalerfassungseinrichtungen verbindbar sind,
- wobei eine programmgesteuerte Logikeinheit mit dem Schaltnetzwerk, den Signalgeneratoren und den Signalerfassungseinrichtungen verbunden ist,
- wobei ein Programmspeicher, in dem ein Steuerprogramm für die Logikeinheit hinterlegt ist, mit der Logikeinheit datentechnisch verbunden ist,
- wobei die Logikeinheit entsprechend dem im Programmspeicher hinterlegten Steuerprogramm
   - das Schaltnetzwerk, die Signalgeneratoren und die Signalerfassungseinrichtungen dynamisch ansteuert,
   - von den Signalerfassungseinrichtungen Messresultate entgegennimmt,
   - anhand der entgegengenommenen Messresultate eine Gesamtbewertung der Leiterplatte vornimmt und
   - zumindest die Gesamtbewertung über eine Schnittstelle ausgibt.

Derartige Prüfanordnungen sind allgemein bekannt. Sie werden insbesondere im Rahmen von Fertigungslinien eingesetzt, um die gefertigten Leiterplatten auf ordnungsgemäßes Funktionieren zu überprüfen.

Bei den Prüfanordnungen des Standes der Technik dient der Grundkörper der Aufnahme der Leiterplatte. Innerhalb des Grundkörpers erfolgt ein Verbinden der Kontakte der Aufnahme mit weiteren, an einer Außenseite des Grundkörpers angeordneten Kontakten einer vorkonfektionierten Adapterschnittstelle. Über die Adapterschnittstelle ist der Grundkörper mit einer oftmals auch als Messmaschine bezeichneten Messanordnung verbindbar, welche das Schaltnetzwerk, die Signalgeneratoren, die Signalerfassungseinrichtungen und die Logikeinheit umfasst. Die Logikeinheit ist in der Regel als Industrie-PC ausgebildet und umfasst ihrerseits intern den Programmspeicher.

Der Gesamtaufbau des Standes der Technik - also einer Messanordnung und einem Grundkörper, welche über die Adapterschnittstelle miteinander verbindbar sind - ist großvolumig und teuer.

Die Aufgabe der vorliegenden Erfindung besteht darin, eine Prüfanordnung der eingangs genannten Art derart auszugestalten, dass sie einfacher und kostengünstiger realisiert ist.

Die Aufgabe wird durch eine Prüfanordnung mit den Merkmalen des Anspruchs 1 gelöst. Vorteilhafte Ausgestaltungen der erfindungsgemäßen Prüfanordnung sind Gegenstand der abhängigen Ansprüche 2 bis 10.

Erfindungsgemäß wird eine Prüfanordnung der eingangs genannten Art dadurch ausgestaltet, dass die Prüfanordnung einen innerhalb des Grundkörpers angeordneten ASIC aufweist, in den das Schaltnetzwerk, die Signalgeneratoren, die Signalerfassungseinrichtungen, die Logikeinheit, der Programmspeicher und die Schnittstelle integriert sind.

Durch diese Vorgehensweise können zum einen die Kosten des Gesamtaufbaus reduziert werden. Weiterhin ist der Gesamtaufbau erheblich kompakter als im Stand der Technik, weil die Messanordnung als solche nunmehr in den Grundkörper integriert ist.

Im Stand der Technik ist die Anzahl von funktionsgleichen Signalgeneratoren in der Regel gleich 1. Es können also zwar mehrere Signalgeneratoren vorhanden sein. Jeder vorhandene Signalgenerator erzeugt aber andere Signale als andere vorhandene Signalgeneratoren. In analoger Weise ist im Stand der Technik die Anzahl von funktionsgleichen Signalerfassungseinrichtungen ebenfalls gleich 1. Es können also zwar mehrere Signalerfassungseinrichtungen vorhanden sein. Jede vorhandene Signalerfassungseinrichtung verarbeitet aber andere Signale als andere vorhandene Signalerfassungseinrichtungen. Es sind zwar selbstverständlich prinzipiell größere Anzahlen möglich. Dies ist jedoch mit erheblichen Kosten verbunden. Diese Vorgehensweise wird im Stand der Technik daher nicht ergriffen. Durch die erfindungsgemäße Vorgehensweise ist es jedoch ohne nennenswerte Mehrkosten möglich, dass die Anzahl von funktionsgleichen Signalgeneratoren und/oder die Anzahl von funktionsgleichen Signalerfassungseinrichtungen größer als 1 ist.

Im Stand der Technik weist das Schaltnetzwerk als Schaltelemente oftmals elektromechanische Schaltelemente auf, insbesondere Relais. Im Gegensatz hierzu weist im Rahmen der vorliegenden Erfindung vorzugsweise das Schaltnetzwerk als Schaltelemente elektronische Schaltelemente auf. Dadurch können insbesondere die Zuverlässigkeit und die Lebensdauer des Schaltnetzwerks deutlich erhöht werden.

Besonders bevorzugt ist, dass zumindest einige der elektronischen Schaltelemente als Multiplexer ausgebildet sind und über die als Multiplexer ausgebildeten Schaltelemente zumindest ein Teil der Signalgeneratoren parallel mit mehreren der Kontakte verbindbar sind und/oder zumindest ein Teil der Signalerfassungseinrichtungen parallel mit mehreren der Kontakte verbindbar sind. Durch diese Ausgestaltung können in vielen Fällen Messungen parallel angestoßen und durchgeführt werden.

Dadurch kann die für das Prüfen einer einzelnen Leiterplatte erforderliche Zeit erheblich verringert werden.

Vorzugsweise ist der Programmspeicher als elektrisch überschreibbarer Remanentspeicher ausgebildet, also als Speicher, dessen Speicherinhalt zwar überschreibbar ist, dessen Speicherinhalt jedoch auch bei Abschalten einer externen Energieversorgung erhalten bleibt. Beispiele derartiger Remanentspeicher sind EEPROMs, Flash-EPROMs und F-RAMs. Im Falle der Ausgestaltung des Programmspeichers als elektrisch überschreibbarer Remanentspeicher ist vorzugsweise das Steuerprogramm dem ASIC über die Schnittstelle zuführbar. Weiterhin ist in diesem Fall das dem ASIC über die Schnittstelle zugeführte Steuerprogramm in den Programmspeicher einschreibbar. Dadurch ist es möglich, das Steuerprogramm nach Bedarf abzuändern und so beispielsweise das Steuerprogramm an einen geänderten Aufbau der Leiterplatte anzupassen. Auch eine Korrektur oder anderweitige Aktualisierung des Steuerprogramms ist möglich.

In der Regel wird die Gesamtbewertung über die Schnittstelle an einen PC ausgegeben. Es ist möglich, dass der PC außerhalb der Prüfanordnung angeordnet ist, also nicht Bestandteil der Prüfanordnung ist. Vorzugsweise umfasst die Prüfanordnung jedoch den PC. Insbesondere ist es möglich, dass der PC in den Grundkörper integriert ist.

Es ist möglich, dass der ASIC automatisch erkennt, wenn eine Leiterplatte in die Aufnahme eingelegt wird. In diesem Fall ist es möglich, dass die Logikeinheit automatisch mit der dynamischen Ansteuerung des Schaltnetzwerks, der Signalgeneratoren und der Signalerfassungseinrichtungen entsprechend dem im Programmspeicher hinterlegten Steuerprogramm beginnt. In der Regel jedoch ist der Logikeinheit über die Schnittstelle ein Startsignal zuführbar. In diesem Fall beginnt die Logikeinheit aufgrund des Startsignals mit den genannten Ansteuerungen.

Die Schnittstelle kann nach Bedarf ausgebildet sein. Insbesondere kann die Schnittstelle als serielle Schnittstelle ausgebildet sein.

Vorzugsweise ist zumindest ein Teil der Messresultate für komplexe Wellenwiderstände zwischen jeweils mindestens zwei der Kontakte charakteristisch, wobei während der Erfassung der dem jeweiligen Messresultat zugrundeliegenden Signale einer dieser beiden Kontakte mit einem der Signalgeneratoren verbunden ist und der andere dieser beiden Kontakte mit einer der Signalerfassungseinrichtungen verbunden ist. Diese Vorgehensweise ist an sich aus der DE 197 48 029 A1 bzw. der korrespondierenden US 6 456 089 B1 bekannt. Durch diese Vorgehensweise kann die Anzahl an einzelnen Vorgängen, die für das vollständige Prüfen der Leiterplatte erforderlich ist, deutlich reduziert werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Prüfanordnung,
- FIG 2: ein Schaltelement eines Schaltnetzwerks,
- FIG 3: einen Ausschnitt eines Schaltnetzwerks,
- FIG 4: einen Teil eines ASICs und
- FIG 5: einen Teil der Prüfanordnung von FIG 1.

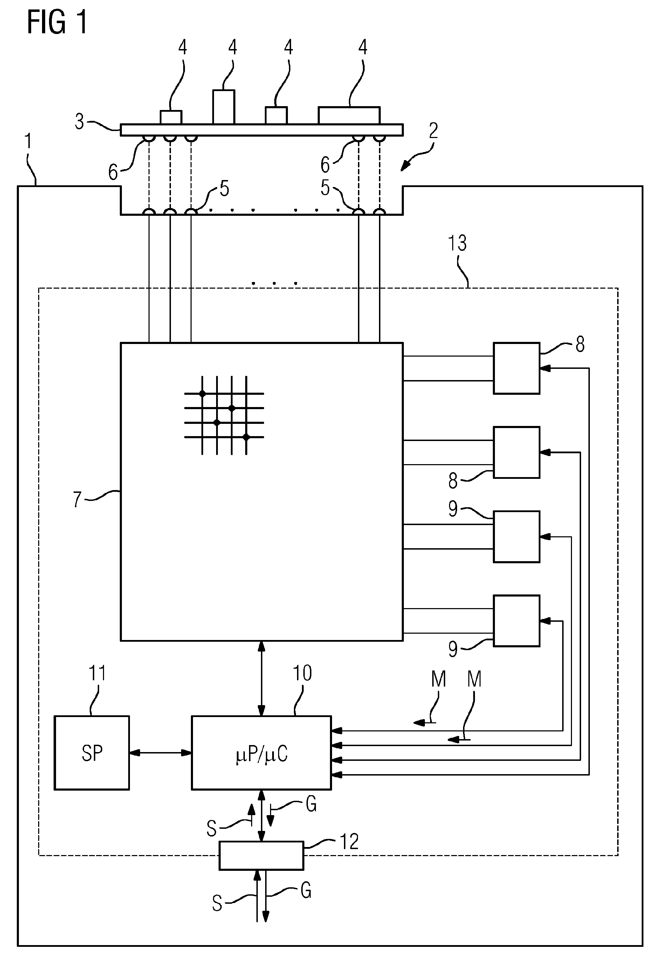

Gemäß FIG 1 weist eine Prüfanordnung einen Grundkörper 1 auf. Der Grundkörper 1 weist eine Aufnahme 2 für eine Leiterplatte 3 auf. Die Leiterplatte 3 ist mit elektronischen Bauelementen 4 bestückt. In der Aufnahme 2 ist eine Vielzahl von Kontakten 5 angeordnet. Die Anzahl an Kontakten 5 ist oftmals erheblich. Sie kann oberhalb von 100 liegen, in manchen Fällen auch oberhalb von 500 oder sogar oberhalb von 1000.

Die Aufnahme 2 ist auf die Leiterplatte 3 abgestimmt. Auch die Anordnung der Kontakte 5 ist auf die Leiterplatte 3 abgestimmt. Wenn die Leiterplatte 3 in die Aufnahme 3 eingesetzt ist, kontaktieren die Kontakte 5 Kontaktstellen 6 der Leiterplatte 3.

Die Kontakte 5 sind über ein Schaltnetzwerk 7 mit einer Anzahl von Signalgeneratoren 8 und einer Anzahl von Signalerfassungseinrichtungen 9 verbindbar. Welcher Kontakt 5 mit welchem Signalgenerator 8 bzw. mit welcher Signalerfassungseinrichtung 9 verbunden ist, ist durch entsprechende Ansteuerung des Schaltnetzwerks 7 dynamisch einstellbar. Die Anzahl an funktionsgleichen Signalgeneratoren 8 beträgt minimal 1. Vorzugsweise sind jedoch entsprechend der Darstellung in FIG 1 mehrere funktionsgleiche Signalgeneratoren 8 vorhanden. In analoger Weise beträgt die Anzahl an funktionsgleichen Signalerfassungseinrichtungen 9 ebenfalls minimal 1. Vorzugsweise sind jedoch entsprechend der Darstellung in FIG 1 mehrere funktionsgleiche Signalerfassungseinrichtungen 9 vorhanden. Die in FIG 1 dargestellte Anzahl von zwei funktionsgleichen Signalgeneratoren 8 und zwei funktionsgleichen Signalerfassungseinrichtungen 9 ist jedoch rein beispielhaft. Es könnten ebenso jeweils mehr als zwei funktionsgleiche Signalgeneratoren 8 und/oder Signalerfassungseinrichtungen 9 vorhanden sein. Ebenso ist es möglich, dass zwar nur ein einziger funktionsgleicher Signalgenerator 8, aber mehrere funktionsgleiche Signalerfassungseinrichtungen 9 vorhanden sind. Auch der umgekehrte Sachverhalt kann gegeben sein. Ebenso ist es möglich, dass mehrere funktionsverschiedene Signalgeneratoren 8 - also Signalgeneratoren 8 verschiedenen Typs - vorhanden sind, wobei bezüglich eines der Typen mehrere funktionsgleiche Signalgeneratoren 8 vorhanden sind und bezüglich eines anderen der Typen nicht. Analoge Vorgehensweisen sind bezüglich der Signalerfassungseinrichtungen 9 möglich.

Es ist weiterhin eine Logikeinheit 10 vorhanden. Sie kann beispielsweise als Mikrocontroller oder als Mikroprozessor ausgebildet sein. Die Logikeinheit 10 ist mit dem Schaltnetzwerk 7, den Signalgeneratoren 8 und den Signalerfassungseinrichtungen 9 verbunden.

Die Logikeinheit 10 ist programmgesteuert. Die Funktion und die Wirkungsweise der Logikeinheit 10 werden daher durch ein Steuerprogramm SP festgelegt. Das Steuerprogramm SP ist in einem Programmspeicher 11 hinterlegt, der mit der Logikeinheit 10 datentechnisch verbunden ist.

Entsprechend dem im Programmspeicher 11 hinterlegten Steuerprogramm SP steuert die Logikeinheit 10 das Schaltnetzwerk 7 dynamisch an. Das Steuerprogramm SP legt also zunächst fest, zu welchen Zeitpunkten welcher Kontakt 5 der Aufnahme 2 mit welchem Signalgenerator 8 bzw. mit welcher Signalerfassungseinrichtung 9 verbunden ist.

Entsprechend dem im Programmspeicher 11 hinterlegten Steuerprogramm SP steuert die Logikeinheit 10 weiterhin die Signalgeneratoren 8 dynamisch an. Das Steuerprogramm SP legt also auch fest, welche Signalgeneratoren 8 zu welchem Zeitpunkt welches Signal abgeben.

Entsprechend dem im Programmspeicher 11 hinterlegten Steuerprogramm SP steuert die Logikeinheit 10 weiterhin die Signalerfassungseinrichtungen 9 dynamisch an. Das Steuerprogramm SP legt also auch fest, welche Signale die Signalerfassungseinrichtungen 9 zu welchem Zeitpunkt entgegennehmen.

Ebenfalls entsprechend dem im Programmspeicher 11 hinterlegten Steuerprogramm SP nimmt die Logikeinheit 10 von den Signalerfassungseinrichtungen 9 Messresultate M entgegen. Es ist möglich, dass die Messresultate M direkt die von den Signalerfassungseinrichtungen 9 erfassten Ströme und Spannungen sind. In diesem Fall wird die Signalauswertung in vollem Umfang von der Logikeinheit 10 vorgenommen. Alternativ ist es möglich, dass die von den Signalerfassungseinrichtungen 9 erfassten Ströme und Spannungen von den Signalerfassungseinrichtungen 9 vorverarbeitet werden und die Messresultate M den Ergebnissen der Vorverarbeitung der Signalerfassungseinrichtungen 9 entsprechen. Auch in diesem Fall wird von der Logikeinheit 10 jedoch weiterhin eine weitergehende Auswertung der Messresultate M vorgenommen.

Die Art der Messungen und die hiermit verbundenen Messresultate M können nach Bedarf bestimmt sein. Oftmals handelt es sich um Messungen von Widerständen, Induktivitäten, Kapazitäten und Diodenkennlinien. Besonders bevorzugt ist, dass zumindest ein Teil der Messresultate M für komplexe Wellenwiderstände zwischen jeweils mindestens zwei der Kontakte 5 charakteristisch ist. Einer dieser beiden Kontakte 5 ist während der Erfassung der dem jeweiligen Messresultat M zugrundeliegenden Signale über das Schaltnetzwerk 7 mit einem der Signalgeneratoren 8 verbunden. Der andere dieser beiden Kontakte 5 ist in diesem Zeitraum über das Schaltnetzwerk 7 mit einer der Signalerfassungseinrichtungen 9 verbunden.

Die von der Logikeinheit 10 vorgenommene Auswertung der Messresultate M entspricht einer Gesamtbewertung G der Leiterplatte 3. Die Gesamtbewertung G gibt zumindest in binärer Form an, ob die Leiterplatte 3 ordnungsgemäß ist oder nicht. Die Gesamtbewertung G kann weiterhin weitere Angaben enthalten, beispielsweise eine Angabe, zu welcher Zeit die Leiterplatte 3 geprüft wurde, mittels welcher Prüfanordnung die Leiterplatte 3 geprüft wurde, und dergleichen mehr. Auch kann die Gesamtbewertung G weitere Angaben enthalten wie beispielsweise einzelne Messresultate M.

Ebenfalls entsprechend dem im Programmspeicher 11 hinterlegten Steuerprogramm SP gibt die Logikeinheit 10 zumindest die Gesamtbewertung G über eine Schnittstelle 12 aus, so dass die Gesamtbewertung G von außerhalb der bisher erläuterten Anordnung zur Kenntnis genommen werden kann. Die Schnittstelle 12 ist vorzugsweise als serielle Schnittstelle ausgebildet.

Das Schaltnetzwerk 7, die Signalgeneratoren 8, die Signalerfassungseinrichtungen 9, die Logikeinheit 10, der Programmspeicher 11 und die Schnittstelle 12 sind Bestandteile eines ASICs 13, in den die genannten Komponenten 7 bis 12 integriert sind. Der ASIC 13 ist gemäß FIG 1 innerhalb des Grundkörpers 1 angeordnet. Insbesondere die Schnittstelle 12 ist von außerhalb des ASICs 13 zugänglich.

Es ist möglich, dass das Einsetzen der Leiterplatte 3 in die Aufnahme 2 automatisch die dynamische Ansteuerung des Schaltnetzwerks 7, der Signalgeneratoren 8 und der Signalerfassungseinrichtungen 9 durch die Logikeinheit 10 entsprechend dem im Programmspeicher 11 hinterlegten Steuerprogramm SP auslöst. In der Regel wartet die Logikeinheit 10 jedoch ab, dass ihr über die Schnittstelle 12 - also diejenige Schnittstelle, über welche die Gesamtbewertung G von der Logikeinheit 10 ausgegeben wird - von außen ein Startsignal S zugeführt wird. In diesem Fall beginnt die Logikeinheit 10 die dynamische Ansteuerung der genannten Komponenten 7 bis 9 erst aufgrund des Startsignals S.

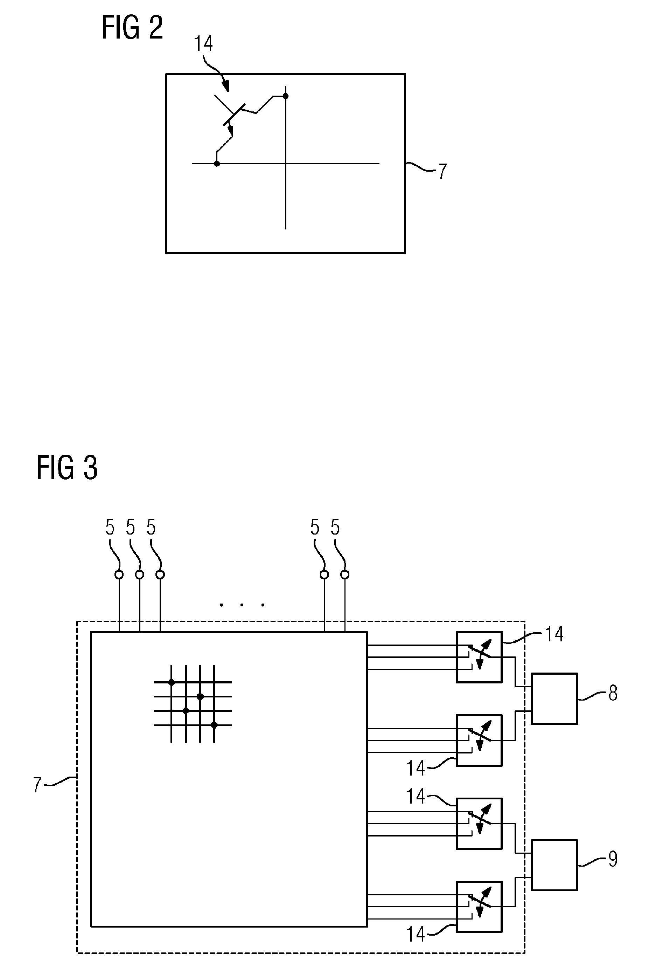

Das Schaltnetzwerk 7 weist gemäß FIG 2 eine Vielzahl von Schaltelementen 14 auf. Dargestellt ist in FIG 2 aus Gründen der Übersichtlichkeit nur ein einzelnes Schaltelemente 14. Die Schaltelemente 14 sind vorzugsweise zumindest teilweise als elektronische Schaltelemente ausgebildet. In der Regel sind sogar alle Schaltelemente 14 als elektronische Schaltelemente ausgebildet. Das Schaltnetzwerk 7 weist also keine mechanisch bewegbaren Teile wie beispielsweise Relais auf.

Gemäß einer in FIG 3 dargestellten Ausgestaltung von FIG 2 sind zumindest einige der Schaltelemente 14 als Multiplexer ausgebildet. Es ist möglich, dass über diese Schaltelemente 14 - also die als Multiplexer ausgebildeten Schaltelemente 14 - zumindest ein Teil der Signalgeneratoren 8 parallel bzw. quasi-parallel mit mehreren der Kontakte 5 verbindbar ist. Alternativ oder zusätzlich ist es möglich, dass über diese Schaltelemente 14 zumindest ein Teil der Signalerfassungseinrichtungen 9 parallel mit mehreren der Kontakte 5 verbindbar ist. Welche Kontakte 5 zu welchen Zeitpunkten mit welchen der Signalgeneratoren 8 und mit welchen der Signalerfassungseinrichtungen 9 verbunden sind, wird nach wie vor die entsprechende Ansteuerung des Schaltnetzwerks 7 durch die Logikeinheit 10 festgelegt. Die parallele Verbindbarkeit besteht weiterhin in der Regel genau genommen nicht exakt, sondern nur im Zeitmultiplex. Dies kann im Rahmen der vorliegenden Erfindung jedoch als parallel angesehen werden.

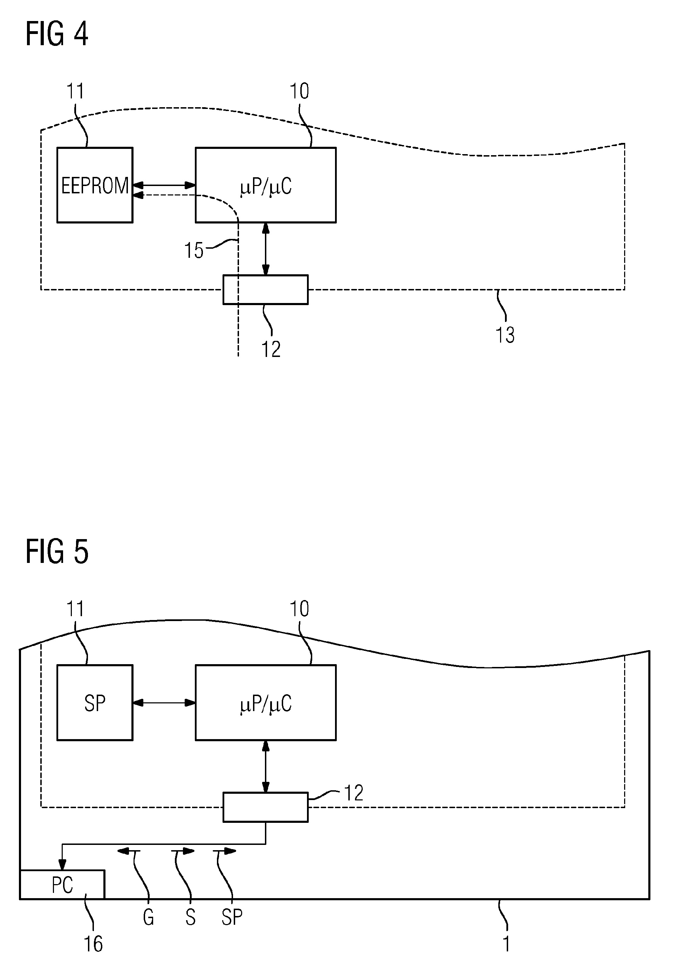

Der Programmspeicher 11 ist entsprechend der Darstellung in FIG 4 vorzugsweise als elektrisch überschreibbarer Remanentspeicher ausgebildet. Geeignete Remanentspeicher sind Fachleuten allgemein bekannt. Die Darstellung in FIG 4, in welcher der Programmspeicher 11 als EEPROM ausgebildet ist, ist rein beispielhaft. Im Falle der elektrischen Überschreibbarkeit des Remanentspeichers ist es insbesondere möglich, dass das Steuerprogramm SP entsprechend dem gestrichelten Pfeil 15 in FIG 4 dem ASIC 13 über die Schnittstelle 12 zugeführt wird. In manchen Fällen kann das Steuerprogramm SP in einem derartigen Fall direkt in den Programmspeicher 11 eingeschrieben werden. Alternativ ist es möglich, dass das Einschreiben in den Programmspeicher 11 entsprechend der Darstellung in FIG 4 indirekt über die Logikeinheit 10 erfolgt. Unabhängig davon, welche Vorgehensweise ergriffen wird, ist es jedoch möglich, das Steuerprogramm SP nachträglich - also nach dem Herstellen des ASICs 13 und auch nach dessen Einbau in den Grundkörper 1 - zu ändern.

Die Kommunikation über die Schnittstelle 12 - also das Ausgeben der Gesamtbewertung G, in der Regel auch das Entgegennehmen des Startsignals S und unter Umständen auch das Entgegennehmen des Steuerprogramm SP - kann prinzipiell mit einer beliebigen Einrichtung erfolgen. In der Regel erfolgt die Kommunikation über die Schnittstelle 12 jedoch entsprechend der Darstellung in FIG 5 mit einem PC 16. Es ist möglich, dass der PC 16 außerhalb der Prüfanordnung angeordnet ist, also kein Bestandteil der Prüfanordnung ist. Vorzugsweise umfasst die Prüfanordnung jedoch entsprechend der Darstellung in FIG 5 den PC 16. Insbesondere kann der PC 16 in den Grundkörper 1 integriert sein.

Die vorliegende Erfindung wurde obenstehend in Verbindung mit einem einzelnen ASIC 13 erläutert. Es ist jedoch ebenso möglich, dass im Grundkörper 1 mehrere ASICs 13 vorhanden sind. In diesem Fall ist in der Regel das Schaltnetzwerk 7 jedes ASICs 13 mit jeweils eigenen Kontakten 5 verbunden. Weiterhin weist jeder ASIC 13 jeweils eine eigene Schnittstelle 12 zur Außenwelt auf, beispielsweise zum PC 16. Der PC 16 jedoch ist, sofern er Bestandteil der Prüfanordnung ist, vorzugsweise auch in diesem Fall nur einmal vorhanden.

Zusammengefasst betrifft die vorliegende Erfindung somit folgenden Sachverhalt:
Eine Prüfanordnung für eine mit elektronischen Bauelementen 4 bestückte Leiterplatte 3 weist einen Grundkörper 1 auf, der seinerseits eine Aufnahme 2 für die Leiterplatte 3 aufweist.
In der Aufnahme 2 ist eine Vielzahl von Kontakten 5 angeordnet, die bei in die Aufnahme 2 eingesetzter Leiterplatte 3 Kontaktstellen 6 der Leiterplatte 3 elektrisch kontaktieren.
Die Kontakte 5 sind über ein Schaltnetzwerk 7 mit Signalgeneratoren 8 und Signalerfassungseinrichtungen 9 verbindbar. Eine programmgesteuerte Logikeinheit 10 ist mit dem Schaltnetzwerk 7, den Signalgeneratoren 8 und den Signalerfassungseinrichtungen 9 verbunden. Ein Programmspeicher 11, in dem ein Steuerprogramm SP für die Logikeinheit 10 hinterlegt ist, ist mit der Logikeinheit 10 datentechnisch verbunden. Entsprechend dem im Programmspeicher 11 hinterlegten Steuerprogramm SP steuert die Logikeinheit 10 das Schaltnetzwerk 7, die Signalgeneratoren 8 und die Signalerfassungseinrichtungen 9 dynamisch an, nimmt von den Signalerfassungseinrichtungen 9 Messresultate M entgegen, nimmt anhand der entgegengenommenen Messresultate M eine Gesamtbewertung G der Leiterplatte 3 vor und gibt zumindest die Gesamtbewertung G über eine Schnittstelle 12 aus. Das Schaltnetzwerk 7, die Signalgeneratoren 8, die Signalerfassungseinrichtungen 9, die Logikeinheit 10, der Programmspeicher 11 und die Schnittstelle 12 sind in einen innerhalb des Grundkörpers 1 angeordneten ASIC 13 der Prüfanordnung integriert.

Die vorliegende Erfindung weist viele Vorteile auf. Insbesondere kann auf einfache Weise eine kostengünstige, kompakte und zuverlässige Prüfanordnung für Leiterplatten geschaffen werden. Weiterhin kann durch das mehrfache Vorhandensein von Signalgeneratoren 8 und Signalerfassungseinrichtungen 9 die Messzeit für eine einzelne Leiterplatte 3 deutlich verringert werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Prüfanordnung für eine mit elektronischen Bauelementen (4) bestückte Leiterplatte (3),
- wobei die Prüfanordnung einen Grundkörper (1) aufweist,
- wobei der Grundkörper (1) eine Aufnahme (2) für die Leiterplatte (3) aufweist,
- wobei in der Aufnahme (2) eine Vielzahl von Kontakten (5) angeordnet ist, die bei in die Aufnahme (2) eingesetzter Leiterplatte (3) Kontaktstellen (6) der Leiterplatte (3) elektrisch kontaktieren,
- wobei die Kontakte (5) über ein Schaltnetzwerk (7) mit einer Anzahl von Signalgeneratoren (8) und einer Anzahl von Signalerfassungseinrichtungen (9) verbindbar sind,
- wobei eine programmgesteuerte Logikeinheit (10) mit dem Schaltnetzwerk (7), den Signalgeneratoren (8) und den Signalerfassungseinrichtungen (9) verbunden ist,
- wobei ein Programmspeicher (11), in dem ein Steuerprogramm (SP) für die Logikeinheit (10) hinterlegt ist, mit der Logikeinheit (10) datentechnisch verbunden ist,
- wobei die Logikeinheit (10) entsprechend dem im Programmspeicher (11) hinterlegten Steuerprogramm (SP)
- - das Schaltnetzwerk (7), die Signalgeneratoren (8) und die Signalerfassungseinrichtungen (9) dynamisch ansteuert,
- - von den Signalerfassungseinrichtungen (9) Messresultate (M) entgegennimmt,
- - anhand der entgegengenommenen Messresultate (M) eine Gesamtbewertung (G) der Leiterplatte (3) vornimmt und
- - zumindest die Gesamtbewertung (G) über eine Schnittstelle (12) ausgibt,
**dadurch gekennzeichnet,**
**dass** die Prüfanordnung einen innerhalb des Grundkörpers (1) angeordneten ASIC (13) aufweist, in den das Schaltnetzwerk (7), die Signalgeneratoren (8), die Signalerfassungseinrichtungen (9), die Logikeinheit (10), der Programmspeicher (11) und die Schnittstelle (12) integriert sind.

2. Prüfanordnung nach Anspruch 1,
**dadurch gekennzeichnet,**
**dass** die Anzahl von funktionsgleichen Signalgeneratoren (8) und/oder die Anzahl von funktionsgleichen Signalerfassungseinrichtungen (9) größer als 1 ist.

3. Prüfanordnung nach Anspruch 1 oder 2,
**dadurch gekennzeichnet,**
**dass** das Schaltnetzwerk (7) als Schaltelemente (14) elektronische Schaltelemente aufweist.

4. Prüfanordnung nach Anspruch 3,
**dadurch gekennzeichnet,**
**dass** zumindest einige der elektronischen Schaltelemente (14) als Multiplexer ausgebildet sind und dass über die als Multiplexer ausgebildeten Schaltelemente (14) zumindest ein Teil der Signalgeneratoren (8) parallel mit mehreren der Kontakte (5) verbindbar sind und/oder zumindest ein Teil der Signalerfassungseinrichtungen (9) parallel mit mehreren der Kontakte (5) verbindbar sind.

5. Prüfanordnung nach einem der obigen Ansprüche,
**dadurch gekennzeichnet,**
**dass** der Programmspeicher (11) als elektrisch überschreibbarer Remanentspeicher ausgebildet ist, dass das Steuerprogramm (SP) dem ASIC (13) über die Schnittstelle (12) zuführbar ist und dass das dem ASIC (13) über die Schnittstelle (12) zugeführte Steuerprogramm (SP) in den Programmspeicher (11) einschreibbar ist.

6. Prüfanordnung nach einem der obigen Ansprüche,
**dadurch gekennzeichnet,**
**dass** die Prüfanordnung einen PC (16) umfasst und dass der ASIC (13) die Gesamtbewertung (G) an den PC (16) ausgibt.

7. Prüfanordnung nach Anspruch 6,
**dadurch gekennzeichnet,**
**dass** der PC (16) in den Grundkörper (1) integriert ist.

8. Prüfanordnung nach einem der obigen Ansprüche,
**dadurch gekennzeichnet,**
**dass** der Logikeinheit (10) über die Schnittstelle (12) ein Startsignal (S) zuführbar ist und dass die Logikeinheit (10) aufgrund des Startsignals (S) mit der dynamischen Ansteuerung des Schaltnetzwerks (7), der Signalgeneratoren (8) und der Signalerfassungseinrichtungen (9) entsprechend dem im Programmspeicher (11) hinterlegten Steuerprogramm (SP) beginnt.

9. Prüfanordnung nach einem der obigen Ansprüche,
**dadurch gekennzeichnet,**
**dass** die Schnittstelle (12) als serielle Schnittstelle ausgebildet ist.

10. Prüfanordnung nach einem der obigen Ansprüche,
**dadurch gekennzeichnet,**
**dass** zumindest ein Teil der Messresultate (M) für komplexe Wellenwiderstände zwischen jeweils mindestens zwei der Kontakte (5) charakteristisch ist, wobei während der Erfassung der dem jeweiligen Messresultat (M) zugrundeliegenden Signale einer dieser beiden Kontakte (5) mit einem der Signalgeneratoren (8) verbunden ist und der andere dieser beiden Kontakte (5) mit einer der Signalerfassungseinrichtungen (9) verbunden ist.

## Geänderte Patentansprüche

### Geänderte Patentansprüche gemäss Regel 137(2) EPÜ.

1. Prüfanordnung für eine mit elektronischen Bauelementen (4) bestückte Leiterplatte (3),
- wobei die Prüfanordnung einen Grundkörper (1) aufweist,
- wobei der Grundkörper (1) eine Aufnahme (2) für die Leiterplatte (3) aufweist,
- wobei in der Aufnahme (2) eine Vielzahl von Kontakten (5) angeordnet ist, die bei in die Aufnahme (2) eingesetzter Leiterplatte (3) Kontaktstellen (6) der Leiterplatte (3) elektrisch kontaktieren,
- wobei die Kontakte (5) über ein Schaltnetzwerk (7) mit einer Anzahl von Signalgeneratoren (8) und einer Anzahl von Signalerfassungseinrichtungen (9) verbindbar sind,
- wobei eine programmgesteuerte Logikeinheit (10) mit dem Schaltnetzwerk (7), den Signalgeneratoren (8) und den Signalerfassungseinrichtungen (9) verbunden ist,
- wobei ein Programmspeicher (11), in dem ein Steuerprogramm (SP) für die Logikeinheit (10) hinterlegt ist, mit der Logikeinheit (10) datentechnisch verbunden ist,
- wobei die Logikeinheit (10) entsprechend dem im Programmspeicher (11) hinterlegten Steuerprogramm (SP)
-- das Schaltnetzwerk (7), die Signalgeneratoren (8) und die Signalerfassungseinrichtungen (9) dynamisch ansteuert,
-- von den Signalerfassungseinrichtungen (9) Messresultate (M) entgegennimmt,
-- anhand der entgegengenommenen Messresultate (M) eine Gesamtbewertung (G) der Leiterplatte (3) vornimmt und
-- zumindest die Gesamtbewertung (G) über eine Schnittstelle (12) ausgibt,
**dadurch gekennzeichnet,**
**dass** die Prüfanordnung einen innerhalb des Grundkörpers (1) angeordneten ASIC (13) aufweist, in den das Schaltnetzwerk (7), die Signalgeneratoren (8), die Signalerfassungseinrichtungen (9), die Logikeinheit (10), der Programmspeicher (11) und die Schnittstelle (12) integriert sind, und dass die Anzahl von funktionsgleichen Signalgeneratoren (8) und/oder die Anzahl von funktionsgleichen Signalerfassungseinrichtungen (9) größer als 1 ist.

2. Prüfanordnung nach Anspruch 1,
**dadurch gekennzeichnet,**
**dass** das Schaltnetzwerk (7) als Schaltelemente (14) elektronische Schaltelemente aufweist.

3. Prüfanordnung nach Anspruch 2,
**dadurch gekennzeichnet,**
**dass** zumindest einige der elektronischen Schaltelemente (14) als Multiplexer ausgebildet sind und dass über die als Multiplexer ausgebildeten Schaltelemente (14) zumindest ein Teil der Signalgeneratoren (8) parallel mit mehreren der Kontakte (5) verbindbar sind und/oder zumindest ein Teil der Signalerfassungseinrichtungen (9) parallel mit mehreren der Kontakte (5) verbindbar sind.

4. Prüfanordnung nach einem der obigen Ansprüche,
**dadurch gekennzeichnet,**
**dass** der Programmspeicher (11) als elektrisch überschreibbarer Remanentspeicher ausgebildet ist, dass das Steuerprogramm (SP) dem ASIC (13) über die Schnittstelle (12) zuführbar ist und dass das dem ASIC (13) über die Schnittstelle (12) zugeführte Steuerprogramm (SP) in den Programmspeicher (11) einschreibbar ist.

5. Prüfanordnung nach einem der obigen Ansprüche,
**dadurch gekennzeichnet,**
**dass** die Prüfanordnung einen PC (16) umfasst und dass der ASIC (13) die Gesamtbewertung (G) an den PC (16) ausgibt.

6. Prüfanordnung nach Anspruch 5,
**dadurch gekennzeichnet,**
**dass** der PC (16) in den Grundkörper (1) integriert ist.

7. Prüfanordnung nach einem der obigen Ansprüche,
**dadurch gekennzeichnet,**
**dass** der Logikeinheit (10) über die Schnittstelle (12) ein Startsignal (S) zuführbar ist und dass die Logikeinheit (10) aufgrund des Startsignals (S) mit der dynamischen Ansteuerung des Schaltnetzwerks (7), der Signalgeneratoren (8) und der Signalerfassungseinrichtungen (9) entsprechend dem im Programmspeicher (11) hinterlegten Steuerprogramm (SP) beginnt.

8. Prüfanordnung nach einem der obigen Ansprüche,
**dadurch gekennzeichnet,**
**dass** die Schnittstelle (12) als serielle Schnittstelle ausgebildet ist.

9. Prüfanordnung nach einem der obigen Ansprüche,
**dadurch gekennzeichnet,**
**dass** zumindest ein Teil der Messresultate (M) für komplexe Wellenwiderstände zwischen jeweils mindestens zwei der Kontakte (5) charakteristisch ist, wobei während der Erfassung der dem jeweiligen Messresultat (M) zugrundeliegenden Signale einer dieser beiden Kontakte (5) mit einem der Signalgeneratoren (8) verbunden ist und der andere dieser beiden Kontakte (5) mit einer der Signalerfassungseinrichtungen (9) verbunden ist.
